(19) Europäisches Patentamt
European Patent Office
Office européen des brevets

(11) EP 4 029 627 A1

(12) EUROPEAN PATENT APPLICATION
published in accordance with Art. 153(4) EPC

(43) Date of publication:
20.07.2022 Bulletin 2022/29

(51) International Patent Classification (IPC):
B22F 1/00 (2022.01)      B22F 7/08 (2006.01)
B22F 9/00 (2006.01)      B82Y 30/00 (2011.01)
B82Y 40/00 (2011.01)      H01B 1/00 (2006.01)
H01B 1/22 (2006.01)      H01B 13/00 (2006.01)
H01L 21/52 (2006.01)      H05K 3/32 (2006.01)

(21) Application number: 20902585.7

(22) Date of filing: 15.12.2020

(52) Cooperative Patent Classification (CPC):
B22F 1/00; B22F 7/08; B22F 9/00; B82Y 30/00;
B82Y 40/00; H01B 1/00; H01B 1/22; H01B 13/00;
H01L 21/52; H05K 3/32

(86) International application number:
PCT/JP2020/046723

(87) International publication number:
WO 2021/125161 (24.06.2021 Gazette 2021/25)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 19.12.2019  JP 2019228845
09.12.2020  JP 2020204335

(71) Applicant: Mitsubishi Materials Corporation
Tokyo 100-8117 (JP)

(72) Inventors:
• YASOSHIMA, Tsukasa
Sanda-shi, Hyogo 669-1339 (JP)
• IWATA, Kotaro
Naka-shi, Ibaraki 311-0102 (JP)
• KATASE, Takuma
Sanda-shi, Hyogo 669-1339 (JP)

(74) Representative: Gille Hrabal
Partnerschaftsgesellschaft mbB
Patentanwälte
Brucknerstraße 20
40593 Düsseldorf (DE)

(54) SILVER PASTE, METHOD FOR PRODUCING SAME, AND METHOD FOR PRODUCING JOINTED ARTICLE

(57) A silver paste is used to be applied directly on the surface (11a) of a copper or copper alloy member to form a silver paste layer (13) and includes a silver powder (12) and a binder (14). The binder (14) includes at least a fatty acid silver salt and an aliphatic amine, and the exchange current density of the binder (14) is within the range of 10 $\mu$A/dm$^2$ or more and 1000 $\mu$A/dm$^2$ or less. It is preferable that the binder (14) includes, as an additive, at least one of diethylene glycol, triethylene glycol, polyethylene glycol, and benzoic acid. It is preferable that the content of the additive in the binder (14) is within the range of 0.003 or more and 0.333 or less in terms of mass ratio (additive/binder).

FIG. 1

**Description**

TECHNICAL FIELD

The present invention relates to a silver paste for joining electronic components, a method for producing this silver paste, and a method for producing a joined body (article) using this silver paste.

Priority is claimed on Japanese Patent Application No. 2019-228845, filed December 19, 2019, and Japanese Patent Application No. 2020-204335, filed December 9, 2020, the contents of which are incorporated herein by reference.

BACKGROUND ART

Conventionally, for the purpose of adhering and fixing (die bonding) semiconductor elements such as high-power LED elements and power semiconductor elements, and electronic components such as semiconductor packages, to the surface of copper or copper alloy members such as Direct Bonded Copper (DBC) substrates (copper-clad substrates) and lead frames by using silver pastes, silver pastes including a silver powder, a thermosetting resin, and a solvent have been used.

Regarding this kind of silver paste, for example, a thermally conductive composition including a silver powder, fine silver particles, a fatty acid silver salt, an amine, and silver resinate is disclosed (see, for example, Patent Document 1). In this thermally conductive composition, the silver powder has an average particle size of 0.3 $\mu$m to 100 $\mu$m, the fine silver particles have an average particle size of primary particles of 50 to 150 nm, the crystallite diameter of the fine silver particles is 20 to 50 nm, and the ratio of the average particle size to the crystallite diameter is 1 to 7.5. This thermally conductive composition further contains an alcohol-based solvent such as methanol, ethylene glycol, and propylene glycol, for viscosity adjustment and the like. In Patent Document 1, it is described that a thermal conductor having a high thermal conductivity can be obtained using a thermally conductive composition configured as such.

Furthermore, regarding another silver paste, there is disclosed an electroconductive paste including fine silver particles having an average particle size of 1 to 200 nm and an organic solvent including a low-swelling organic solvent having a blanket swelling ratio of 2.0% or less, the electroconductive paste having a content percentage of the low-swelling organic solvent of 3.0 to 30 wt% (see, for example, Patent Document 2). Patent Document 2 describes that with regard to this electroconductive paste, it is preferable that an organic component is attached to at least a portion of the surface of the fine silver particles, and it is preferable that this organic component includes an amine and a carboxylic acid from the viewpoints of dispersibility and electroconductivity of the fine silver particles. Furthermore, in Patent Document 2, it is described that the low-swelling organic solvent having a blanket swelling ratio of 2.0% or less is preferably a solvent having a hydroxyl group as a functional group, while the low-swelling organic solvent may be, for example, a polyhydric alcohol having a plurality of hydroxyl groups or another monohydric alcohol solvent, and it is described that examples of the polyhydric alcohol having 2 or 3 hydroxyl groups include glycerin, 1,2,4-butanetriol, 1,2,6-hexanetriol, ethylene glycol, diethylene glycol, 1,2-butanediol, propylene glycol, and 2-methylpentane-2,4-diol. It is described in Patent Document 2 that this electroconductive paste can form a fine electroconductive pattern having sufficient electroconductivity and satisfactory adhesiveness to a substrate.

[Citation List]

[Patent Documents]

[Patent Document 1] Japanese Patent No. 5872545 (Claim 1, paragraph [0006], and paragraph [0051])
[Patent Document 2] Japanese Patent No. 6329703 (Claim 1, paragraph [0010], paragraph [0034], paragraph [0035], paragraph [0052], paragraph [0055], and paragraph [0056])

SUMMARY OF INVENTION

Technical Problem

On the surface of a DBC substrate (copper-clad substrate) and a copper or copper alloy member such as a lead frame, on which a silver paste is applied, an oxide coating film of CuO or CuO$_2$ is likely to be formed. Therefore, a metallized layer such as silver plating or nickel plating is formed on the surface of a copper or copper alloy member, a silver paste is applied on the metallized layer, and electronic components such as chip elements are joined. However, when an electronic component such as a chip element was joined to a copper or copper alloy member by using the silver pastes shown in Patent Documents 1 and 2 without forming a metallized layer, it was difficult to join the electronic component to the copper or copper alloy member with high strength.

Furthermore, regarding the heating atmosphere when joining the electronic component to the copper or copper alloy member, a nitrogen atmosphere having a low oxygen concentration is desirable from the viewpoint of suppressing the formation of the oxide coating film on the surface of the copper or copper alloy member. However, there was a problem that when the heating at the time of joining electronic components is performed in a nitrogen atmosphere having a low oxygen concentration by using the silver pastes shown in Patent Documents 1 and 2, the sinterability of the silver component in the silver paste is decreased, and the joining strength is lowered.

An object of the present invention is to provide a silver paste that joins an electronic component to a copper or copper alloy member with high strength when the silver paste is applied directly on the surface of a copper or copper alloy member having no metallized layer such as silver plating or nickel plating and heated in a nitrogen atmosphere having a low oxygen concentration, a method for producing the silver paste, and a method for producing a joined body.

Solution to Problem

A first aspect of the present invention is a silver paste including a silver powder, a binder, and a solvent, in which the binder includes at least a fatty acid silver salt and an aliphatic amine, and an exchange current density of the binder is within a range of 10 $\mu A/dm^2$ or more and 1000 $\mu A/dm^2$ or less. More preferably, the exchange current density is within a range of 20 $\mu A/dm^2$ or more and 500 $\mu A/dm^2$ or less and may be within a range of 100 $\mu A/dm^2$ or more and 300 $\mu A/dm^2$ or less. The exchange current density of the binder in the present specification is an exchange current density measured in a state in which a working electrode Cu, a counter electrode Ag, and a reference electrode Pt are disposed in the binder, by changing an electrode potential from +250 mV to -250 mV with reference to the open circuit potential by a linear sweep voltammetry method (LSV method/potential scanning method), and the measurement conditions will be described later.

A silver paste according to a second aspect of the present invention is an invention based on the first aspect, and the binder includes, as an additive, at least one of diethylene glycol, triethylene glycol, polyethylene glycol, and benzoic acid.

A silver paste according to a third aspect of the present invention is an invention based on the first or second aspect, and a content of the additive in the binder is within a range of 0.003 or more and 0.333 or less in terms of mass ratio, additive/binder. The content is more preferably 0.020 or more and 0.200 or less.

A silver paste according to a fourth aspect of the present invention is an invention based on any one of the first to third aspects, and the silver powder includes first silver particles having a particle size of 100 nm or more and less than 500 nm in a range of 55% by volume or more and 95% by volume or less, includes second silver particles having a particle size of 50 nm or more and less than 100 nm in a range of 5% by volume or more and 40% by volume or less, and includes third silver particles having a particle size of less than 50 nm in a range of 5% by volume or less.

A method for producing a silver paste according to a fifth aspect of the present invention includes a step of mixing a fatty acid silver salt and an aliphatic amine to obtain a mixture; a step of heating and stirring the mixture and then cooling the mixture to obtain a mixed solution; and a step of kneading the mixed solution, the silver powder, and the additive of the second or third aspect to obtain a silver paste.

A method for producing a joined body according to a sixth aspect of the present invention includes a step of applying the silver paste according on any one of the first to fourth aspects directly on a surface of a copper or copper alloy member to form a silver paste layer; a step of laminating an electronic component on the silver paste layer to produce a laminated body; and a step of heating the laminated body in a nitrogen atmosphere having an oxygen concentration of 1000 ppm or less on a volume basis, thereby sintering the silver powder in the silver paste layer to form a joining layer, and producing a joined body in which the copper or copper alloy member and the electronic component are joined with the joining layer interposed therebetween. More preferably, the oxygen concentration is 700 ppm or less on a volume basis, and the oxygen concentration may be 500 ppm or less or may be 100 ppm or less. The lower limit value of the oxygen concentration is not limited but may be 0.1 ppm.

ADVANTAGEOUS EFFECTS OF INVENTION

The silver paste according to the first aspect of the present invention contains a silver powder and a binder including at least a fatty acid silver salt and an aliphatic amine, and the exchange current density of the binder is within the range of 10 $\mu A/dm^2$ or more and 1000 $\mu A/dm^2$ or less. In this silver paste, at least a portion of the fatty acid silver salt and at least a portion of the aliphatic amine react with each other, and thus a complex is formed. When the silver paste is heated, silver nanoparticles are precipitated out from this complex.

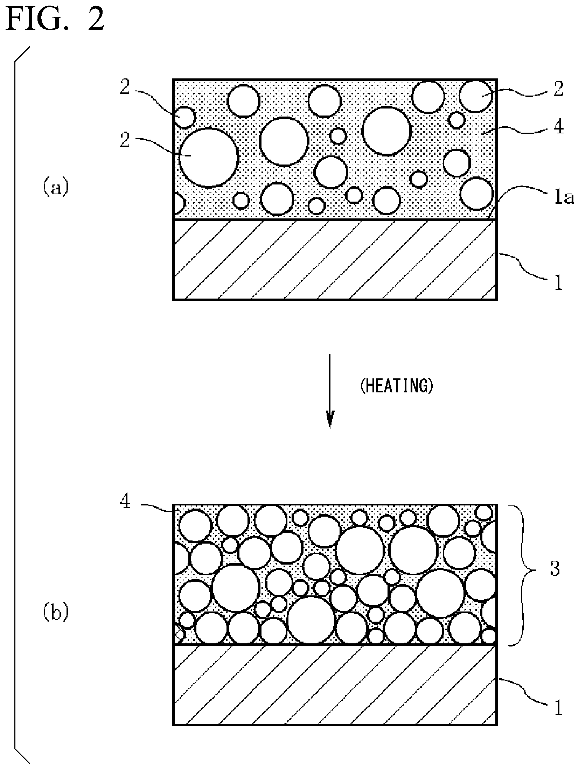

In a conventional silver paste, the precipitation of silver nanoparticles from the complex at the time of being heated occurs rapidly, the precipitated silver nanoparticles are interposed between silver powder particles in the silver paste, and as shown in Fig. 2(a) and Fig. 2(b), a silver paste layer 3 is formed while the silver powder 2 is stacked on the surface 1a of a copper or copper alloy member 1 having no metallized layer. In Fig. 2, reference numeral 4 represents a binder.

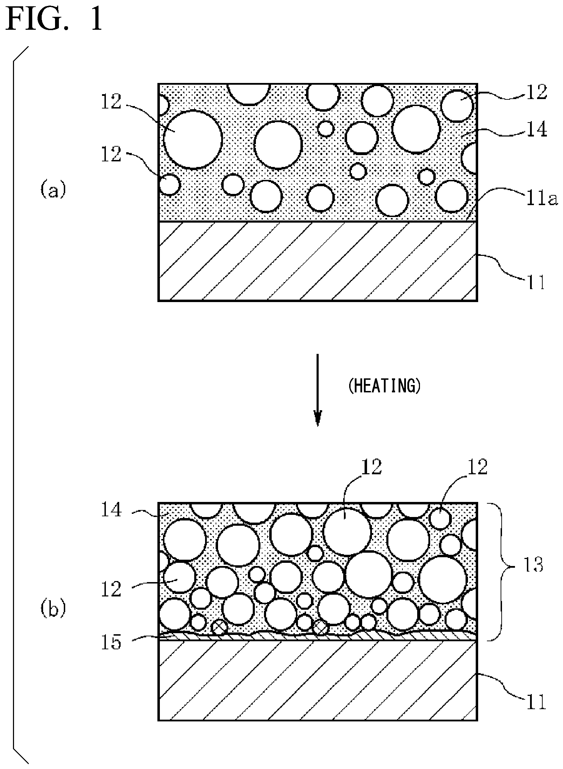

In each aspect of the present invention, since the exchange current density of the binder is within the above-described range, the precipitation of silver nanoparticles from the complex when the silver paste is heated is delayed, the precipitated silver nanoparticles are interposed between silver powder particles in the silver paste, the silver nanoparticles gather while undergoing grain growth on the surface 11a of the copper or copper alloy member 11 as shown in Fig. 1(a) and Fig. 1(b), and a layer of silver nanoparticles that have undergone grain growth is formed as a pseudo-silver plating film 15. In Fig. 1, reference numeral 12 represents a silver powder, reference numeral 13 represents a silver paste layer, and reference numeral 14 represents a binder.

In each aspect of the present invention, the silver powder in the silver paste layer is sintered by subsequent heating, with the pseudo-silver plating film 15 interposed therebetween, and the silver paste layer becomes a joining layer (not shown in the diagram). Due to the presence of the pseudo-silver plating film 15, even when heating is performed in a nitrogen atmosphere having a low oxygen concentration, an electronic component is joined with higher strength to the surface of the copper or copper alloy member having no metallized layer, with this joining layer interposed therebetween, as compared with the conventional case where a pseudo-silver plating film is not provided.

In the silver paste according to the second aspect of the present invention, the binder includes, as an additive, at least one of diethylene glycol, triethylene glycol, polyethylene glycol, and benzoic acid. This additive weakens the reducing power of the complex when the silver paste is heated. As a result, the precipitation of silver nanoparticles from the complex can be delayed, and thereby a pseudo-silver plating film can be formed on the surface of the copper or copper alloy member.

In the silver paste according to the third aspect of the present invention, the content of the additive in the binder is within the range of 0.003 or more and 0.333 or less in terms of mass ratio, additive/binder. When the binder includes the additive at the above-described mass ratio, the exchange current density of the binder is easily controlled to be within the range of 10 $\mu$A/dm$^2$ or more and 1000 $\mu$A/dm$^2$ or less, and as a result, the precipitation of silver nanoparticles from the complex when the silver paste is heated is delayed, so that a pseudo-silver plating film can be formed more accurately on the surface of the copper or copper alloy member.

In the silver paste according to the fourth aspect of the present invention, since the silver powder includes first silver particles having a particle size of 100 nm or more and less than 500 nm in the range of 55% by volume or more and 95% by volume or less; includes second silver particles having a particle size of 50 nm or more and less than 100 nm in a range of 5% by volume or more and 40% by volume or less; and includes third silver particles having a particle size of less than 50 nm in a range of 5% by volume or less, the silver powder has a relatively broad particle size distribution, and as a result, the gaps between the first, second, and third silver particles become small and dense during sintering, so that a joining layer with fewer voids can be produced.

In the method for producing a silver paste according to the fifth aspect of the present invention, since a mixed solution is prepared and then the additive is mixed into the silver powder together with the mixed solution, there is an effect of preventing the additive from inhibiting a reaction between the fatty acid silver salt and the aliphatic amine. Furthermore, in the mixed liquid, at least a portion of the fatty acid silver salt and at least a portion of the aliphatic amine react with each other and form a complex. When the silver paste is heated, the precipitation of silver nanoparticles from the complex when the silver paste is heated is delayed by the additive, and as a result, the silver paste can form a pseudo-silver plating film on the surface of the copper or copper alloy member.

In the method for producing a joined body according to the sixth aspect of the present invention, first, the silver paste according to any one of the first to fourth aspects is applied directly on the surface of a copper or copper alloy member to form a silver paste layer. Here, the phrase "applied directly on the surface of a copper or copper alloy member" means that the silver paste is applied on the surface of a copper or copper alloy member that does not have a metallized layer such as silver, nickel, or gold formed on the surface of the copper or copper alloy member. Next, an electronic component is laminated on the copper or copper alloy member, with a silver paste layer interposed therebetween, to produce a laminated body, and this laminated body is heated. When the silver paste is heated, silver nanoparticles are precipitated out from the complex. Due to the additive, the precipitation of silver nanoparticles from the complex at the time of heating the silver paste is delayed, and as a result, a pseudo-silver plating film is formed on the surface of the copper or copper alloy member. The silver powder is sintered by further continued heating, with the pseudo-silver plating film interposed therebetween, to form a joining layer. Therefore, it is possible for an electronic component to be directly joined to the surface of this copper or copper alloy member with high strength, with this joining layer interposed therebetween, even in a nitrogen atmosphere in which the oxygen concentration at the time of heating is 1000 ppm or less on a volume basis, or even when the copper or copper alloy member is a copper or copper alloy member having no metallized layer. By adopting a nitrogen atmosphere in which the oxygen concentration during heating is 1000 ppm or less on a volume basis, oxidation of the copper or copper alloy member during heating is prevented, and the electronic component is joined with higher strength.

BRIEF DESCRIPTION OF DRAWINGS

Fig. 1(a) is a schematic view of a state in which a silver paste according to the present invention is applied on the surface of a copper or copper alloy member having no metallized layer. Fig. 1(b) is a schematic view of a state in which the applied silver paste and the copper or copper alloy member are heated.

Fig. 2(a) is a schematic view of a state in which a conventional silver paste is applied on the surface of a copper or copper alloy member having no metallized layer. Fig. 2(b) is a schematic view of a state in which the applied silver paste and the copper or copper alloy member are heated.

DESCRIPTION OF EMBODIMENTS

Next, embodiments for carrying out the present invention will be described. The silver paste includes a silver powder and a binder, and the binder includes at least a fatty acid silver salt and a aliphatic amine. The silver paste may further include a solvent. Hereinafter, each component will be described in detail.

[Silver powder]

The silver powder of the present embodiment is not particularly limited, and a commercially available silver powder can be used. Preferably, the silver powder includes first silver particles (first group of silver particles), second silver particles (second group of silver particles), and third silver particles (third group of silver particles), whose particle sizes are different from each other. All of these first, second, and third silver particles aggregate with each other as primary particles to form aggregates (silver powder). It is preferable that the first silver particles have a particle size of 100 nm or more and less than 500 nm, and when the total amount of the first, second, and third silver particles is taken as 100% by volume, it is preferable that the amount of the first silver particles included is in the range of 55% by volume or more and 95% by volume or less. Furthermore, it is preferable that the second silver particles have a particle size of 50 nm or more and less than 100 nm, and when the total amount of the first, second, and third silver particles is taken as 100% by volume, it is preferable that the amount of the second silver particles included is in the range of 5% by volume or more and 40% by volume or less. In addition, it is preferable that the third silver particles have a particle size of less than 50 nm, and when the total amount of the first, second, and third silver particles is taken as 100% by volume, it is preferable that the amount of the third silver particles included is in the range of 5% by volume or less. The term "volume" as used herein indicates the volume of the silver particles themselves.

The contents of the first, second, and third silver particles are each limited to the above-described ranges because when the silver powder has a relatively broad particle size distribution, dense aggregates with small gaps between the first, second, and third silver particles are formed at the time of sintering, and thereby a joining layer having fewer voids is likely to be produced. The purity of silver in the first, second, and third silver particles is preferably 90% by mass or higher, and more preferably 99% by mass or higher. This is because the first, second, and third silver particles having higher silver purity melt more easily, and therefore, the first, second, and third silver particles can be sintered at a relatively low temperature. Regarding elements other than silver in the first, second, and third silver particles, Au, Cu, Pd, and the like may be included.

Furthermore, when the total amount of the first, second, and third silver particles is taken as 100% by volume, it is preferable that the amount of the first silver particles included, the first silver particles having a particle size of 100 nm or more and less than 500 nm, is in the range of 70% by volume or more and 90% by volume or less; it is preferable that the amount of the second silver particles included, the second silver particles having a particle size of 50 nm or more and less than 100 nm, is in the range of 10% by volume or more and 30% by volume or less; and it is preferable that the amount of the third silver particles included, the third silver particles having a particle size of less than 50 nm, is in the range of 1% by volume or less. When the particle size distributions of the first, second, and third silver particles are within the above-described ranges, the effect that dense aggregates of silver powder having small gaps between the first, second, and third silver particles during sintering can be formed is enhanced, and a joining layer with even fewer voids is likely to be produced. The particle sizes of the first, second, and third silver particles can be obtained by, for example, measuring projected areas of the first, second, and third silver particles in the silver powder by using a SEM (Scanning Electron Microscope: scanning microscopic) photograph, calculating the equivalent circle diameters (diameters of circles having the same areas as the projected areas of the first, second, and third silver particles) from the obtained projected areas, and converting these calculated particle sizes into particle sizes on a volume basis. A specific example of the measuring method will be described in Examples that will be described later.

It is preferable that the silver powder includes an organic material composed of an organic reducing agent or a decomposition product thereof, and it is preferable that this organic material is decomposed or volatilized at a temperature of 150°C. Furthermore, examples of the organic reducing agent include ascorbic acid, formic acid, and tartaric acid. The organic material composed of an organic reducing agent or a decomposition product thereof suppresses oxidation of the surfaces of the first, second, and third silver particles when the first, second, and third silver particles are stored in a state of aggregated secondary particles (that is, silver powder before being produced into a silver paste), and makes it easy to suppress mutual diffusion, that is, diffusion joining during storage, of the first, second, and third silver particles. Furthermore, the organic material has an effect of being easily decomposed or volatilized when a silver paste including aggregates of silver particles is printed on a surface to be joined of a member as an object of joining and heated, thus exposing highly active surfaces of the first, second, and third silver particles, and thereby making a sintering reaction between the first, second, and third silver particles easier to proceed. In addition, a decomposition product or volatile matter of the organic material has a reducing ability of reducing an oxide film on the surfaces to be joined of a member as an object of joining.

Incidentally, when the organic material included in the silver powder remains in the joining layer, there is a risk that the organic material may be decomposed over time, causing voids to be generated in the joining layer. Therefore, it is preferable that the content of the organic material is adjusted to 2% by mass or less when the total amount of the first, second, third silver particles is taken as 100% by mass. More preferably, the content of the organic material is 1.5% by mass or less and may be 0.7% by mass or less. However, in order to obtain the above-described effects brought by the organic material, it is preferable that the content of the organic material is 0.05% by mass or more when the total amount of the first, second, and third silver particles is taken as 100% by mass.

More preferably, the content of the organic material may be 0.1% by mass or more.

[Binder]

The binder of the present embodiment includes a fatty acid silver salt and a aliphatic amine. The binder according to the present embodiment is such that the exchange current density is within the range of 10 $\mu$A/dm$^2$ or more and 1000 $\mu$A/dm$^2$ or less. As a result, when the silver paste is heated, precipitation of silver nanoparticles from the complex is delayed, and a pseudo-silver plating film is easily formed on the surface of a copper or copper alloy member. When the exchange current density of the binder is less than 10 $\mu$A/dm$^2$, the precipitation of silver nanoparticles from the complex when the silver paste is heated is excessively delayed, a pseudo-silver plating film is less likely to be formed on the surface of a copper or copper alloy member, and the joining strength of the joined body is decreased. When the exchange current density of the binder is more than 1000 $\mu$A/dm$^2$, since the precipitation of silver nanoparticles from the complex when the silver paste is heated is accelerated, and silver nucleation takes priority, a pseudo-silver plating film is less likely to be formed on the surface of a copper or copper alloy member, and the joining strength of the joined body is decreased. In order for the binder to have an exchange current density in the above-described predetermined range, it is desirable that the binder includes an additive. It is possible to control the exchange current density to be within the above-described predetermined range by selecting the type of the aliphatic amine or solvent included in the silver paste that will be described later, instead of incorporating an additive into the binder. The method for measuring the exchange current density of the binder will be described later. More preferably, the exchange current density may be 20 $\mu$A/dm$^2$ or more and 500 $\mu$A/dm$^2$ or less or may be 100 $\mu$A/dm$^2$ or more and 300 $\mu$A/dm$^2$ or less.

[Fatty acid silver salt]

Examples of the fatty acid silver salt of the present embodiment include silver acetate, silver oxalate, silver propionate, silver myristate, and silver butyrate.

[Aliphatic amine]

Examples of the aliphatic amine of the present embodiment include a primary amine, a secondary amine, and a tertiary amine. It is desirable that the carbon number of the aliphatic amine is preferably adjusted to 8 to 12. When the carbon number is too small, the boiling point of the aliphatic amine tends to be low, and therefore, there is a risk that the printability of the silver paste may be deteriorated. When the carbon number is too large, sintering of the silver particles in the silver paste may be hindered, and there is a risk that a joined body having sufficient strength may not be obtained. Specific examples include, as the primary amine, ethylhexylamine, aminodecane, dodecylamine, nonylamine, hexylamine, and octylamine; as the secondary amine, dimethylamine, diethylamine, and dioctylamine; and as the tertiary amine, trimethylamine and triethylamine. The carbon number may be 10 to 12.

With regard to the silver paste, it is preferable that the molar ratio of the aliphatic amine to the fatty acid silver salt, that is, the ratio of molar amount of the aliphatic amine/molar amount of the fatty acid silver salt, is within the range of 1.5 or more and 3 or less. When the proportion of the aliphatic amine is small, the proportion of the fatty acid silver salt, which is a solid, is relatively high, and therefore, uniform dispersion in the silver paste is less likely to occur, and there is a risk that voids may be easily produced inside the joining layer obtained by heating. When the proportion of the aliphatic amine is too large, an excess amount of the aliphatic amine is likely to cause grain growth of the silver powder in the silver paste, and since the paste viscosity is likely to be decreased, there is a risk that the printability may be deteriorated. The ratio of molar amount of the aliphatic amine/molar amount of the fatty acid silver salt is more preferably within the range of 1.7 or more and 2.8 or less, and even more preferably within the range of 2.0 or more and 2.5 or less.

Since the silver paste includes a fatty acid silver salt and an aliphatic amine, at least a portion of this fatty acid silver salt reacts with at least a portion of the aliphatic amine to form a complex. This complex is presumed to be a silver-amine complex.

[Additive]

The binder of the present embodiment may further include an additive. The additive may be at least one of compounds among diethylene glycol, triethylene glycol, polyethylene glycol, and benzoic acid. As described above, when the binder includes an additive, it is easy to control the exchange current density of the binder to be within the range of 10 $\mu$A/dm$^2$ or more and 1000 $\mu$A/dm$^2$ or less. However, by selecting the types of the aliphatic amine included in the silver paste and the solvent that will be described below, the exchange current density is within the above-described predetermined range, and therefore, in that case, the additive is not necessarily required. When the binder includes an additive, it is preferable that the content of the additive in the binder is within the range of 0.003 or more and 0.333 or less, and preferably 0.020 or more and 0.200 or less, in terms of mass ratio, additive/binder.

[Solvent]

The silver paste may further include a solvent. Examples of the solvent include an alcohol-based solvent, water, an acetate-based solvent, a hydrocarbon-based solvent, and mixtures thereof. Examples of the alcohol-based solvent include $\alpha$-terpineol, isopropyl alcohol, ethylhexanediol, 1-hexanol, 1-octanol, and mixtures thereof; examples of the acetate-based solvent include butyl carbitol acetate; and examples of the hydrocarbon-based solvent include decane, dodecane, tetradecane, and mixtures thereof.

It is preferable that the content of the solvent is within the range of 0% by mass or more and 30% by mass or less when the total amount of the silver paste is taken as 100% by mass. Even when the content of the solvent is 0% by mass, there is no problem because the aliphatic amine and/or the additive in the silver paste accomplishes functions as a solvent. When the content is more than 30% by mass, the viscosity is too low, and the shape retainability at the time of coating is likely to be deteriorated. A more preferable content of the solvent is within the range of 0% by mass or more and 10% by mass or less.

[Resin]

The silver paste may further include a resin. Examples of the resin include an epoxy-based resin, a silicone-based resin, an acrylic resin, and mixtures thereof. Examples of the epoxy-based resin include a bisphenol A type epoxy resin, a novolac type epoxy resin, a cycloaliphatic epoxy resin, and mixtures thereof; examples of the silicone-based resin include a methylsilicone resin, an epoxy-modified silicone resin, a polyester-modified silicone resin, and mixtures thereof; and examples of the acrylic resin include an acrylate-based monomer resin. These resins are cured by heating the silver paste, and a cured body thereof fills the voids of a sintered body of the silver powder. As the voids of the sintered body of the silver powder are filled with a cured body of a thermosetting resin composition, the mechanical strength of the joining layer is enhanced, and further, a decrease in the joining strength under the load of cooling-heating cycle is suppressed. It is preferable that the content of the resin is within the range of 0% by mass or more and 3% by mass or less when the total amount of the silver paste is taken as 100% by mass. When the content of the resin is more than 3% by mass, there is a risk that sintering of the silver powder may be hindered and the mechanical strength of the joining layer may be decreased. A more preferable content of the resin is within the range of 0% by mass or more and 2.5% by mass or less, and an even more preferable content is within the range of 0% by mass or more and 2.0% by mass or less.

[Method for producing silver paste]

A method for producing a silver paste configured as such will be described.

First, a fatty acid silver salt, an aliphatic amine, and a solvent are prepared, the fatty acid silver salt, the aliphatic amine, and the solvent are mixed, and a mixture is prepared. Here, when the aliphatic amine is a liquid at room temperature, the solvent does not necessarily have to be mixed. When the total amount of this mixture is taken as 100% by mass, it is preferable to mix the fatty acid silver salt at a proportion of 0.1% by mass or more and 40% by mass or less, the aliphatic amine at a proportion of 0.1% by mass or more and 60% by mass or less, and the solvent at a proportion of 80% by mass or less. Here, the mixing proportions of the fatty acid silver salt, the aliphatic amine, and the solvent are limited to be within the above-described ranges because precipitation and the like are not likely to occur in the mixed liquid. When the total amount of the fatty acid silver salt, the aliphatic amine, and the solvent is taken as 100% by mass, more preferred mixing proportions are 20% by mass or more and 30% by mass or less for the fatty acid silver salt, 20% by mass or more and 40% by mass or less for the aliphatic amine, and 40% by mass or more and 60% by mass or less for the solvent.

Next, it is preferable to prepare a mixed liquid by heating the mixture at a temperature in the range of 30°C or higher and 100°C or lower and stirring the mixture for a duration in the range of 5 minutes or longer and 10 hours or shorter. After preparation, this mixed liquid is cooled to room temperature (25°C). As a result, a mixed solution of the fatty acid silver salt, the aliphatic amine, and the solvent (hereinafter, simply referred to as mixed solution) is prepared. Here, the heating temperature and the heating time for the mixture are set within the above-described ranges in order to make it easy to uniformly mix the fatty acid silver salt, the aliphatic amine, and the solvent.

Next, after the mixed solution, the silver powder, and the additive are mixed, the resulting mixture is stirred in a planetary stirrer or the like and is further kneaded by a three-roll mill or the like, and thereby a silver paste is obtained. Here, when the silver paste is taken as 100% by mass, it is preferable that the content of the silver powder is adjusted to be within the range of 50% by mass or more and 95% by mass or less. More preferably, the content of the silver powder is within the range of 70% by mass or more and 95% by mass or less and may be within the range of 80% by mass or more and 93% by mass or less. In the silver paste, when the content of the silver powder is small, there is a risk that the viscosity of the silver paste may be lowered so that coating defects such as sagging may easily occur, and when the content is too high, there is a risk that the viscosity may increase so that the handleability may be deteriorated. The additive and the mixed solution may be mixed first and then the silver powder may be mixed, or after the mixed solution and the silver powder are mixed, the additive may be mixed. It is preferable that the additive is mixed such that the content thereof in the binder is within the range of 0.003 or more and 0.333 or less in terms of mass ratio, additive/binder. The mass ratio may also be within the range of 0.020 or more and 0.200 or less. As described above, by selecting the type of the aliphatic amine or the solvent, it may be unnecessary to include the additive in the binder. By mixing the components at this mass ratio, the reducing power of the complex when the silver paste is heated is weakened, the precipitation of silver nanoparticles from the complex is delayed, and a pseudo-silver plating film is easily formed on the surface of the copper or copper alloy member. Furthermore, the silver paste may include the above-described resin. In this case, the cooling-heating cycle characteristics are enhanced. Furthermore, after the mixed solution and the additive are mixed, the silver powder may be added and mixed to obtain a silver paste.

With regard to this mixed solution, the molar ratio of the aliphatic amine to the fatty acid silver salt, that is, the ratio of molar amount of the aliphatic amine/molar amount of the fatty acid silver salt, is preferably adjusted to be within the range of 1.5 or more and 3 or less, and more preferably within the range of 1.7 or more and 2.8 or less. When a silver paste is produced using such a mixed solution, the molar ratio of the aliphatic amine to the fatty acid silver salt in the mixed solution is the molar ratio of the aliphatic amine to the fatty acid silver salt in the silver paste.

<Method for producing joined body>

A method for producing a joined body by using the silver paste will be described.

In the production method of the present embodiment, a copper or copper alloy member and an electronic component having no metallized layer are prepared. Examples of the electronic component include semiconductor elements such as a semiconductor chip, a high-power LED element, and a power semiconductor element; and packages. Examples of the copper or copper alloy member include a DBC substrate (copper-clad substrate) and a lead frame made of a copper alloy. However, the copper or copper alloy member is not limited to the DBC substrate and the lead frame. Next, the silver paste is applied directly on the surface of the copper or copper alloy member by, for example, a metal mask method or the like to form a silver paste layer having a desired planar shape.

Next, an electronic component is laminated on the copper or copper alloy member, with a silver paste layer interposed therebetween, and a laminated body is produced. Then, this laminated body is heated in a nitrogen atmosphere having a low oxygen concentration of 1000 ppm or less, preferably 700 ppm or less, more preferably 200 ppm or less, and even more preferably 100 ppm or less, on a volume basis. For example, the laminated body is heated and retained for 10 minutes or more and 240 minutes or less (heating time) within the temperature range of 120°C or higher and 280°C or lower (heating temperature). By this heating, silver nanoparticles are precipitated out from the complex formed by a reaction of at least a portion of the fatty acid silver salt and at least a portion of the aliphatic amine in the silver paste. The additive in the silver paste weakens the reducing power of the complex and delays the precipitation of silver nanoparticles from the complex, and a portion of the precipitated silver nanoparticles form a pseudo-silver plating film on the surface of the copper or copper alloy member. Through continued heating, the silver powder (first silver particles, second silver particles, and third silver particles) in the silver paste layer is sintered together with the remaining precipitated silver nanoparticles and the pseudo-silver plating film, and thus a joining layer is formed. As a result, a joined body in which an electronic component is directly joined, with high strength, to a copper or copper alloy member having no metallized layer on the surface, with this joining layer interposed therebetween, even when heating is performed in a nitrogen atmosphere having a low oxygen concentration, can be produced. Here, the heating temperature and the heating time for the laminated body are limited to be within the above-described ranges because when the heating time is less than 10 minutes, there is a risk that it may be difficult for sintering to proceed, and even when the heating time is more than 240 minutes, the cost increases without any change in the joining characteristics. Incidentally, at the time of heating, the laminated body does not have to be subjected to pressurization in the lamination direction. This is based on the reason that the pressurization step is omitted and the cost is reduced.

EXAMPLES

Next, Examples of the present invention will be described in detail together with Comparative Examples. First, mixed solutions 1 to 18 and mixed solutions 20 to 22, which are silver paste precursors that do not include silver powders, will be described, and next, Examples 1 to 28 and Comparative Examples 1 to 9 that used these mixed solutions will be described.

[Production Example for silver paste precursor (mixed solution)]

<Mixed solution 1>

First, silver acetate (fatty acid silver salt), aminodecane (aliphatic amine), and butyl carbitol acetate (solvent) were prepared, and when the total amount of the fatty acid silver salt, the aliphatic amine, and the solvent was taken as 100% by mass, 22% by mass of silver acetate (fatty acid silver salt), 41.3% by mass of aminodecane (aliphatic amine), and 36.7% by mass of butyl carbitol acetate (solvent) were measured, and these were introduced into a glass container together with a stirring bar of a stirrer. Then, the container was mounted on a hot plate that had been heated to 50°C, the mixture was stirred for one hour while the stirring bar of the stirrer was rotated at 300 rpm, and a mixed liquid was prepared. Next, the container storing this mixed liquid was removed from the hot plate, and the temperature of the mixed liquid was lowered to room temperature. As a result, a mixed solution 1 which is a mixed solution of a fatty acid silver salt and an aliphatic amine (hereinafter, simply referred to as a mixed solution), which is a silver paste precursor, was prepared.

<Mixed solutions 2-18 and mixed solutions 20-22>

Regarding mixed solutions 2 to 18 and mixed solutions 20 to 22, the compounds of the types shown in Table 1 were used as the fatty acid silver salt, the aliphatic amine, and the solvent, and the fatty acid silver salt, the aliphatic amine, and the solvent were blended at each of the proportions shown in Table 1. No solvent was used for mixed solution 18. Since mixed solution 20 did not include a fatty acid silver salt and mixed solution 21 did not include an aliphatic amine, those were not mixed solutions; however, in the present specification, for convenience, mixed solutions 20 and 21 will also be referred to as mixed solutions. Furthermore, in the column for the type of the fatty acid silver salt in Table 1 and Table 2, "A1" represents silver acetate, "A2" represents silver oxalate, and "A3" represents silver myristate. Furthermore, in the column for the type of the aliphatic amine in Table 1 and Table 2, "B1" represents aminodecane, "B2" represents hexylamine, "B3" represents octylamine, "B4" represents dodecylamine, and "B5" represents dioctylamine. In addition, in the column for the type of the solvent in Table 1 and Table 2, "C1" represents butyl carbitol acetate, "C2" represents water, "C3" represents α-terpineol, "C4" represents 2-ethyl-1,3-hexanediol, "C5" represents 1-hexanol, "C6" represents 1-octanol, and "C7" represents polyethylene glycol having an average molecular weight of 200.

## TABLE 1

| Type of mixed solution | Fatty acid silver salt | | Aliphatic amine | | Molar ratio (aliphatic amine/fatty acid silver salt) | Solvent | |
|---|---|---|---|---|---|---|---|
| | Type | Blending amount (mass%) | Type | Blending amount (mass%) | | Type | Blending amount (mass%) |
| Mixed solution 1 | A1 | 22.0 | B1 | 41.3 | 2 | C1 | 36.7 |
| Mixed solution 2 | A1 | 13.2 | B1 | 24.8 | 2 | C1 | 62.0 |
| Mixed solution 3 | A1 | 16.5 | B1 | 31.0 | 2 | C1 | 52.5 |
| Mixed solution 4 | A1 | 33.0 | B1 | 62.0 | 2 | C1 | 5.0 |
| Mixed solution 5 | A1 | 22.0 | B1 | 30.7 | 1.5 | C1 | 47.3 |
| Mixed solution 6 | A1 | 22.0 | B1 | 62.0 | 3 | C1 | 16.0 |
| Mixed solution 7 | A1 | 22.0 | B2 | 26.7 | 2 | C1 | 51.3 |
| Mixed solution 8 | A1 | 22.0 | B3 | 34.1 | 2 | C1 | 43.9 |
| Mixed solution 9 | A1 | 22.0 | B4 | 48.7 | 2 | C1 | 29.3 |
| Mixed solution 10 | A1 | 22.0 | B5 | 63.7 | 2 | C1 | 14.3 |
| Mixed solution 11 | A2 | 22.0 | B1 | 22.7 | 2 | C1 | 55.3 |
| Mixed solution 12 | A3 | 22.0 | B1 | 20.7 | 2 | C1 | 57.3 |
| Mixed solution 13 | A1 | 13.2 | B1 | 24.8 | 2 | C2 | 62.0 |
| Mixed solution 14 | A1 | 13.2 | B1 | 24.8 | 2 | C3 | 62.0 |
| Mixed solution 15 | A1 | 13.2 | B1 | 24.8 | 2 | C4 | 62.0 |
| Mixed solution 16 | A1 | 13.2 | B1 | 24.8 | 2 | C5 | 62.0 |
| Mixed solution 17 | A1 | 13.2 | B1 | 24.8 | 2 | C6 | 62.0 |
| Mixed solution 18 | A1 | 35.0 | B4 | 65.0 | 2 | - | - |
| Mixed solution 20 | None | 0 | B1 | 41.3 | - | C1 | 58.7 |
| Mixed solution 21 | A1 | 22.0 | None | 0 | - | C1 | 78.0 |
| Mixed solution 22 | A1 | 22.0 | B1 | 41.3 | 2 | C7 | 36.7 |

A1: Silver acetate  
A2: Silver oxalate  
A3: Silver myristate  

B1: Aminodecane  
B2: Hexylamine  
B3: Octylamine  
B4: Dodecylamine  
B5: Dioctylamine  

C1: Butyl carbitol acetate  
C2: Water  
C3: α-Terpineol  
C4: 2-Ethyl-1,3-hexanediol  
C5: 1-Hexanol  
C6: 1-Octanol  
C7: Polyethylene glycol (molecular weight 200)  

<Comparison Test 1 and evaluation>

Each of the mixed solutions 1 to 18 and mixed solutions 20 to 22 was separately heated at 130°C for 10 minutes while being stirred, subsequently 1 g of each of these mixed solutions was dropped on a silicon wafer and dried under reduced pressure at a temperature of 25°C, and thereby a wafer having the dried matter attached to the surface was produced. Then, the surface of this wafer was observed with a SEM (scanning electron microscope), 1,000 particles attached to the surface were counted, projected areas of the extracted particles (primary particles) were measured using an image processing software program (Image-J (National Institutes of Health: development)), the equivalent circle diameters were calculated from the obtained projected areas, and these were designated as primary particle sizes. The equivalent circle diameter was not measured for particles having a site where the contour could not be visually recognized. The obtained primary particle sizes were converted into volume-based particle sizes, and the average value of the volume-based particle sizes was designated as average particle size of the dried matter. Furthermore, a sample in which silver powder was generated in the dried matter was considered to be "acceptable", and a sample in which silver powder was not generated in the dried matter, or a sample in which the primary particle size of the silver powder could not be measured was considered to be "unacceptable". The average particle size of silver powder in the dried matter and the determination results are presented in Table 2. Table 2 also shows the types of the fatty acid silver salt, the types of the aliphatic amine, and the types of the solvent.

TABLE 2

| Type of mixed solution | Type of fatty acid silver salt | Type of aliphatic amine | Type of solvent | Average particle size of dried matter (nm) | Determination results |
|---|---|---|---|---|---|
| Mixed solution 1 | A1 | B1 | C1 | 60 | Acceptable |
| Mixed solution 2 | A1 | B1 | C1 | 60 | Acceptable |
| Mixed solution 3 | A1 | B1 | C1 | 60 | Acceptable |
| Mixed solution 4 | A1 | B1 | C1 | 60 | Acceptable |
| Mixed solution 5 | A1 | B1 | C1 | 70 | Acceptable |
| Mixed solution 6 | A1 | B1 | C1 | 40 | Acceptable |
| Mixed solution 7 | A1 | B2 | C1 | 100 | Acceptable |
| Mixed solution 8 | A1 | B3 | C1 | 70 | Acceptable |
| Mixed solution 9 | A1 | B4 | C1 | 40 | Acceptable |
| Mixed solution 10 | A1 | B5 | C1 | 40 | Acceptable |
| Mixed solution 11 | A2 | B1 | C1 | 60 | Acceptable |
| Mixed solution 12 | A3 | B1 | C1 | 50 | Acceptable |
| Mixed solution 13 | A1 | B1 | C2 | 60 | Acceptable |
| Mixed solution 14 | A1 | B1 | C3 | 40 | Acceptable |
| Mixed solution 15 | A1 | B1 | C4 | 50 | Acceptable |
| Mixed solution 16 | A1 | B1 | C5 | 40 | Acceptable |
| Mixed solution 17 | A1 | B1 | C6 | 50 | Acceptable |
| Mixed solution 18 | A1 | B4 | - | 50 | Acceptable |
| Mixed solution 20 | None | B1 | C1 | Not generated | Unacceptable |
| Mixed solution 21 | A1 | None | C1 | Not measurable | Unacceptable |
| Mixed solution 22 | A1 | B1 | C7 | 50 | Acceptable |

A1: Silver acetate
A2: Silver oxalate
A3: Silver myristate

B1: Aminodecane
B2: Hexylamine
B3: Octylamine
B4: Dodecylamine
B5: Dioctylamine

C1: Butyl carbitol acetate
C2: Water
C3: α-Terpineol
C4: 2-Ethyl-1,3-hexaminediol
C5: 1-Hexanol
C6: 1-Octanol
C7: Polyethylene glycol
(molecular weight 200)

As is obvious from Table 2, in the mixed solution 20 that did not include a fatty acid silver salt, since silver that is expected to contribute to densification of the joining layer was not included, generation of silver powder was not observed during SEM (scanning electronmicroscope) observation, and the determination results were rated as unacceptable.

Furthermore, in the mixed solution 21 that did not include an aliphatic amine, since a uniform mixed solution was not obtained, and the dried matter on the silicon wafer formed lumps, silver powder could not be measured by SEM (scanning electronmicroscope) observation, and the determination results were rated as unacceptable. This is speculated to be because, since the mixed solution 21 did not include an aliphatic amine, decomposition of the fatty acid silver salt did not sufficiently proceed, and silver powder was not produced.

In contrast to these, in the mixed solutions 1 to 18 and mixed solution 22 that included fatty acid silver salts and aliphatic amines, generation of a silver powder having an average particle size of 50 nm or more and 100 nm or less was observed during SEM (scanning electronmicroscope) observation, and the determination results were rated as acceptable. This is speculated to be because, since the mixed solutions 1 to 18 and mixed solution 22 included fatty acid silver salts and aliphatic amines, the organic materials were rapidly decomposed by heating, and silver nanoparticles on which a highly active surface was exposed were easily formed.

[Production Example for silver paste]

First, a method for preparing a silver powder that is used as a raw material for the silver pastes prepared in Examples 1 to 28 and Comparative Examples 1 to 9 will be described. These ten kinds of silver powder are shown in "No. 1 to No. 10" in Table 3 below. Table 3 also shows the organic material content in the ten kinds of silver powder.

TABLE 3

| | First silver particles Particle size 100 nm or more and less than 500 nm (vol%) | Second silver particles Particle size 50 nm or more and less than 100 nm (vol%) | Third silver particles Particle size less than 50 nm (vol%) | Organic material content (mass%) |
|---|---|---|---|---|
| No. 1 | 80 | 17.5 | 2.5 | 0.2 |
| No. 2 | 60 | 39 | 1 | 0.3 |
| No. 3 | 94 | 5 | 1 | 0.5 |
| No. 4 | 80 | 19 | 1 | 0.5 |
| No. 5 | 56 | 39 | 5 | 0.4 |
| No. 6 | 93 | 5 | 2 | 0.5 |
| No. 7 | 94 | 1 | 5 | 0.5 |
| No. 8 | 40 | 50 | 10 | 0.5 |
| No. 9 | 60 | 33 | 7 | 0.2 |
| No. 10 | 100 | 0 | 0 | 0.3 |

The silver powder (mixture/aggregates of first, second, and third silver particles) of No. 1 shown in Table 3 was prepared as follows. First, fine silver particles (raw material powder A) in which the D10, D50, and D90 were 20 nm, 50 nm, and 100 nm, respectively, and fine silver particles (raw material powder B) in which the D10, D50, and D90 were 150 nm, 300 nm, and 500 nm, respectively, were prepared. The method for preparing the fine silver particles (raw material powder A) and the fine silver particles (raw material powder B) will be described later. D10 is a value at which the ratio of particles smaller than or equal to that particle size in the mixture is 10%, D50 is a value at which the ratio of particles smaller than or equal to that particle size in the mixture is 50%, and D90 is a value at which the ratio of particles smaller than or equal to that particle size in the mixture is 90%. The D10, D50, and D90 of each kind of the fine silver particles were determined from a particle size distribution curve of the fine silver particles. The particle size distribution curve of the fine silver particles was measured by a dynamic light scattering method that will be described below. For silver powder No. 1, raw material powder A and raw material powder B were mixed at proportions that gave a mass ratio of 1:3 to obtain a fine silver particle mixture.

Regarding the dynamic light scattering method, first, 0.1 g of fine silver particles were introduced into 20 g of ion-exchanged water, and the resulting mixture was irradiated with ultrasonic waves at 25 kHz for 5 minutes to disperse the fine silver particles in the ion-exchanged water. Next, the obtained dispersion liquid of fine silver particles was poured into an observation cell for a dynamic light scattering type particle size distribution analyzer (Horiba, Ltd.: "LB-550"), and the particle size distribution was measured according to the procedure of this apparatus.

Next, this fine silver particle mixture, sodium ascorbate (organic reducing agent), and water were mixed at proportions that gave a mass ratio of 10:1:89, and a fine silver particle slurry was prepared. This fine silver particle slurry was heated at a temperature of 90°C for 3 hours, and thus the fine silver particles were subjected to a reduction treatment. Next, the fine silver particle slurry was allowed to cool naturally to room temperature, and then solid matter was separated and collected by using a centrifuge. This collected solid matter (water-containing fine silver particle aggregates) was washed with water several times and dried to obtain silver powder No. 1 (mixture/aggregates of first, second, and third silver particles) as shown in Table 3.

The silver powder of No. 2 was obtained in the same manner as in the above-described preparation method for the silver powder of No. 1, except that the mixing proportions of the fine silver particles (raw material powder A) and the fine silver particles (raw material powder B) were set to 1:1 as a mass ratio.

The silver powder of No. 3 was obtained in the same manner as in the above-described preparation method for the silver powder of No. 1, except that the mixing proportions of the fine silver particles (raw material powder A) and the fine silver particles (raw material powder B) were set to 1:5 as a mass ratio.

The silver powder of No. 4 was obtained by the following method. To 1200 g of ion-exchanged water maintained at 50°C, 900 g of an aqueous solution of silver nitrate maintained at 50°C and 600 g of an aqueous solution of sodium citrate maintained at 50°C were simultaneously added dropwise for 5 minutes, and a silver citrate slurry was prepared. While the aqueous solution of silver nitrate and the aqueous solution of sodium citrate were simultaneously added dropwise into the ion-exchanged water, the ion-exchanged water was continuously stirred. Furthermore, the concentration of silver nitrate in the aqueous solution of silver nitrate was 66% by mass, and the concentration of citric acid in the aqueous solution of sodium citrate was 56% by mass. Next, to the silver citrate slurry maintained at 50°C, 300 g of an aqueous solution of sodium formate maintained at 50°C was added dropwise over 30 minutes to obtain a mixed slurry. The concentration of formic acid in this aqueous solution of sodium formate was 58% by mass. Next, the mixed slurry was subjected to a predetermined heat treatment. Specifically, the mixed slurry was heated to a maximum temperature of 60°C at a rate of temperature increase of 10°C/hour and maintained at 60°C (maximum temperature) for 30 minutes, and then the temperature was lowered to 20°C over 60 minutes. As a result, a silver powder slurry was obtained. The silver powder slurry was introduced into a centrifuge and was rotated for 10 minutes at a speed of rotation of 1000 rpm. As a result, the liquid layer in the silver powder slurry was removed, and a dehydrated and desalted silver powder slurry was obtained. This dehydrated and desalted silver powder slurry was dried by freeze-drying method for 30 hours to obtain a silver powder of No. 4 having a particle size distribution of volume-based particle sizes as shown in Table 3.

The silver powder of No. 5 was obtained in the same manner as in the above-described preparation method for the silver powder of No. 1, except that the mixing proportions of the fine silver particles (raw material powder A) and the fine silver particles (raw material powder B) were set to 2:1 as a mass ratio.

The silver powder of No. 6 was obtained in the same manner as in the above-described preparation method for the silver powder of No. 1, except that the mixing proportions of the fine silver particles (raw material powder A) and the fine silver particles (raw material powder B) were set to 1:6 as a mass ratio.

The silver powder of No. 7 was obtained in the same manner as in the above-described preparation method for the silver powder of No. 1, except that the mixing proportions of the fine silver particles (raw material powder A) and the fine silver particles (raw material powder B) were set to 2:9 as a mass ratio.

The silver powder of No. 8 was obtained in the same manner as in the above-described preparation method for the silver powder of No. 1, except that only the fine silver particles (raw material powder A) were used without mixing the fine silver particles (raw material powder A) and the fine silver particles (raw material powder B).

The silver powder of No. 9 was obtained in the same manner as in the above-described preparation method for the silver powder of No. 1, except that the mixing proportions of the fine silver particles (raw material powder A) and the fine silver particles (raw material powder B) were set to 4:3 as a mass ratio.

The silver powder of No. 10 was obtained in the same manner as in the above-described preparation method for the silver powder of No. 1, except that the mixing proportions of the fine silver particles (raw material powder A) and the fine silver particles (raw material powder B) were set to 1:9 as a mass ratio.

The method for producing the fine silver particles (raw material powder A) is as follows. First, silver nitrate, citric acid, and potassium hydroxide were mixed in distilled water at an equimolar ratio (1:1:1) with respect to silver ions in silver nitrate, to produce a suspension. Hydrazine acetate was added to this suspension at a molar ratio of 2 to 1 of silver ions. Fine silver particles (raw material powder A) were obtained by causing the suspension, to which hydrazine acetate had been added, to react at a liquid temperature of 40°C, and subjecting the obtained reaction liquid slurry to washing, collecting, and drying.

Furthermore, fine silver particles (raw material powder B) were obtained by mixing an aqueous solution of silver nitrate, aqueous ammonia, and distilled water, preparing an aqueous solution of silver ammine having a silver concentration of 22 g/L, adding a reducing solution to this aqueous solution of silver ammine, and subjecting a silver particle slurry thus produced to washing, collecting, and drying. Incidentally, the reducing solution is a mixed liquid of an aqueous solution of hydroquinone and an aqueous solution of sodium hydroxide, and is a liquid in which the oxidation-reduction potential has been adjusted to -380 mV based on Ag/AgCl.

<Method for measuring particle size distribution of silver particles>

Five hundred images of aggregates (secondary particles) in which first, second, and third silver particles were aggregated were acquired using SEM, and the particle sizes of the silver particles (primary particles) included in each silver particle aggregate were measured. At this time, the apparatus magnification for SEM was set to 100000 times. From the five hundred SEM images of silver particle aggregates, silver particles from which the entire contour of a silver particle (primary particle) could be visually recognized, were extracted. Next, projected areas of the extracted silver particles were measured using an image processing software program (Image-J), equivalent circle diameters were calculated from the obtained projected areas, and these were designated as the particle sizes of the silver particles. The equivalent circle diameter was not measured for silver particles having a site where the contour could not be visually recognized. The particle sizes of the obtained silver particles were converted into volume-based particle sizes, and a particle size distribution of the volume-based particle sizes was determined. The results are presented in Table 3.

<Method for measuring content of organic material>

The contents of organic materials in the silver powders of No. 1 to No. 10 were calculated by the following method. The silver powder before mixing with the mixed solution was measured and heated in air at a temperature of 150°C for 30 minutes. After heating, the silver powder was allowed to cool naturally to room temperature, and the mass of the silver powder was measured. The content of an organic material was calculated from the following Formula (1). As a result, the content of the organic material was 0.2% by mass.

$$\text{Content of organic material (mass\%)} = \{(A - B)/A\} \times 100 \quad ........ \quad (1)$$

However, A in Formula (1) represents the mass of the silver powder before heating, and B represents the mass of the silver powder after heating. The obtained results are presented in Table 3.

Next, Examples 1 to 28 and Comparative Examples 1 to 9 for preparing silver pastes will be described.

<Example 1>

In order to adjust the amount of the silver paste to 100% by mass, mixed solution 1 (24.50% by mass), the silver powder of No. 1 (75.00% by mass), and diethylene glycol (D1) (0.50% by mass) as an additive were mixed and then stirred in a planetary stirrer, and the mixture was further kneaded with a three-roll mill. As a result, a silver paste was obtained. This silver paste was designated as Example 1.

<Examples 2 to 28 and Comparative Examples 1 to 9>

Regarding 36 kinds of silver pastes of Examples 2 to 28 and Comparative Examples 1 to 9, each mixed solution was prepared by using the fatty acid silver salt, the aliphatic amine, and the solvent shown in Table 1 and Table 2, and at the same time, the silver powder, the mixed solution, and the additive were blended at the proportions shown in Table 4 and Table 5. The silver pastes were prepared in the same manner as in Example 1, except that the silver powder, the mixed solution, and the additive shown in Table 4 and Table 5 were blended. However, Comparative Examples 2 and 4 did not form pastes for the reason that will be described later. In Example 5 and Example 6, two kinds of additives were used. In Example 12, Comparative Example 1, Comparative Example 2, Comparative Example 5, Comparative Example 6, and Comparative Example 9, no additive was used.

The mixed solutions used in Examples 1 to 28 and Comparative Examples 1 to 9 are indicated as either "Mixed solutions 1 to 18" or "Mixed solutions 20 to 22" in the column for the type of the mixed solution in Table 4 and Table 5. Furthermore, in Examples 1 to 28 and Comparative Examples 1 to 9, any one of ten kinds (No. 1 to No. 10) of silver powders having different particle size distributions as shown in Table 3 is blended in. The silver powders used in Examples 1 to 28 and Comparative Examples 1 to 9 are indicated by any of "No. 1 to No. 10" in the column for the type of the silver powder in Table 4 and Table 5. Furthermore, in the column for the type of the additive in Table 4 and Table 5, "D1" represents diethylene glycol, "D2" represents triethylene glycol, "D3" is a polyethylene glycol having an average molecular weight of 1000, "D4" represents benzoic acid, and "D5" represents ethylene glycol. The content (mass ratio) of the additive in the binder is shown in Table 4 and Table 5.

<Comparison Test 2 and evaluation>

[Exchange current density]

The exchange current density of the binder before producing the silver pastes of Examples 1 to 28 and Comparative Examples 1 to 9 was measured by the following method. The exchange current density refers to the current density when the electrode reaction is in an equilibrium state. When the electrode reaction is in an equilibrium state, the absolute values of the positive current and the negative current are equal. This current is called the exchange current, and the exchange current per unit area of the electrode is called the exchange current density. Using an electrochemical measuring device (manufactured by BAS, Inc., ALS700 series), a working electrode Cu and a counter electrode Ag were disposed in the binder, and a reference electrode Pt was further disposed. Specifically, 10 mL of the binder and a working electrode Cu having an exposed area of 0.0025 $dm^2$ were used in a glass container having an inner diameter of $\varphi$20 mm, and the electrodes were disposed such that the distance between the electrodes (distance between the working electrode Cu and the counter electrode Ag) was 10 mm. The current value was measured by changing the electrode potential from +250 mV to -250 mV with reference to the open circuit potential by a linear sweep voltammetry method (LSV (potential scanning) method). The scan speed was 100 mV/sec.

The exchange current density ($i_0$) was calculated by low overvoltage approximation by using the equation $i \approx (i_0 F\eta)/(RT)$. In the above-described equation, R represents the gas constant; T represents the absolute temperature (K); and $\eta$ represents the overvoltage (V).

The potential at which the current density of the measured data reaches zero was designated as equilibrium potential, and a total of ten current value data were extracted at every 1 mV from (equilibrium potential - 1 mV) to (equilibrium potential - 10 mV).

The extracted ten current value data were approximated by the least squares method, and the gradient was designated as the exchange current density. The exchange current densities of the binders of Examples 1 to 28 and Comparative Examples 1 to 9 are shown in Table 4 and Table 5.

[Method for measuring joining strength of joined body]

Joined bodies were produced using 35 kinds of the silver pastes of Examples 1 to 28 and Comparative Examples 1, 3, and 5 to 9. In Comparative Examples 2 and 4, since pastes were not formed, measurement of the joining strength of the joined bodies was not performed. First, a Si wafer (thickness: 200 $\mu$m) that measured 10 mm on each side and was provided with gold plating on the surface, the Si wafer imitating an electronic component, was prepared. An oxygen-free copper plate (thickness: 1 mm) that measured 20 mm on each side was prepared as a copper or copper alloy member. No metallized layer was formed on the surface of this copper plate. Next, a silver paste was applied on the surface of the oxygen-free copper plate by a metal mask method, and thus a silver paste layer was formed. Next, the Si wafer was loaded on the silver paste layer, and thereby a laminated body was produced. In addition, this laminated body was heated by maintaining the laminated body at a temperature of 250°C for 60 minutes in a nitrogen atmosphere having an oxygen concentration of 100 ppm on a volume basis, and then a Si wafer was joined to the oxygen-free copper plate, with the joining layer interposed therebetween. These joined bodies were used as the joined bodies of Examples 1 to 28 and Comparative Examples 1, 3, and 5 to 9. Incidentally, the laminated bodies were not pressurized in the lamination direction. The joining strength of these joined bodies was measured as follows.

The joining strength of the 35 kinds of joined bodies of Examples 1 to 28 and Comparative Examples 1, 3, and 5 to 9 were measured using a shear strength evaluation tester (manufactured by TRY PRECISION Technology Co., Ltd.: MFM-1500HF). Specifically, the measurement of the joining strength was performed by horizontally fixing the oxygen-free copper plate of the joined body, pressing the Si wafer of the joined body from the side in the horizontal direction by means of a shear tool at a position 50 $\mu$m above the surface (top face) of the joining layer, and then measuring the strength at the time when the Si wafer was fractured. The moving speed of the shear tool was set to 0.1 mm/sec. The strength test was performed three times per one condition, and the arithmetic mean value of those was used as the measured value of the joining strength.

[Stability of silver paste]

The 35 kinds of silver pastes obtained in Examples 1 to 28 and Comparative Examples 1, 3, and 5 to 9 were placed in a container, sealed, and stored at 25°C for two weeks. The viscosities of each of the silver pastes before storage and after storage were measured with a spiral viscometer (manufactured by Malcom Co., Ltd.: PCU-02V).

The measurement conditions were 25°C and a speed of rotation of 10 rpm. The case where the viscosity of the silver paste after storage increased by 25% or more from the viscosity of the silver paste before storage, was rated as "Acceptable"; the case where the viscosity increased by 10% or more and less than 25% was rated as "Good"; and the case where the viscosity increased by less than 10% was rated as "Excellent". The results are presented in Table 4 and Table 5.

TABLE 4

| | Silver powder | | Mixed solution | | Additive | | (Additive /binder) (mass ratio) | Binder exchange current density (μA/dm²) | Joining strength of joined body (MPa) | Stability of silver paste |
|---|---|---|---|---|---|---|---|---|---|---|
| | Blending proportion (mass%) | Type | Type | Blending proportion (mass%) | Type | Blending proportion (mass%) | | | | |
| Example 1 | 75.00 | No.1 | Mixed solution 1 | 24.50 | D1 | 0.50 | 0.020 | 300 | 26 | Excellent |
| Example 2 | 80.00 | No.1 | Mixed solution 1 | 19.00 | D2 | 1.00 | 0.050 | 420 | 25 | Excellent |
| Example 3 | 85.00 | No.1 | Mixed solution 1 | 14.90 | D3 | 0.10 | 0.007 | 440 | 21 | Good |
| Example 4 | 90.00 | No.1 | Mixed solution 1 | 9.90 | D4 | 0.10 | 0.010 | 460 | 20 | Acceptable |
| Example 5 | 85.00 | No.2 | Mixed solution 1 | 13.00 | D1<br>D2 | 1.00<br>1.00 | 0.133 | 210 | 27 | Excellent |
| Example 6 | 85.00 | No.3 | Mixed solution 1 | 14.00 | D3<br>D4 | 0.05<br>0.95 | 0.067 | 400 | 26 | Acceptable |
| Example 7 | 85.00 | No.4 | Mixed solution 1 | 13.00 | D1 | 2.00 | 0.133 | 280 | 29 | Excellent |
| Example 8 | 85.00 | No.1 | Mixed solution 5 | 13.00 | D2 | 2.00 | 0.133 | 310 | 26 | Excellent |
| Example 9 | 85.00 | No.1 | Mixed solution 6 | 13.00 | D3 | 2.00 | 0.133 | 320 | 25 | Good |

18

(continued)

| | Silver powder | | Mixed solution | | Additive | | (Additive /binder) (mass ratio) | Binder exchange current density ($\mu$A/dm$^2$) | Joining strength of joined body (MPa) | Stability of silver paste |
|---|---|---|---|---|---|---|---|---|---|---|
| | Blending proportion (mass%) | Type | Type | Blending proportion (mass%) | Type | Blending proportion (mass%) | | | | |
| Example 10 | 85.00 | No.1 | Mixed solution 7 | 13.00 | D4 | 2.00 | 0.133 | 350 | 26 | Acceptable |
| Example 11 | 85.00 | No.1 | Mixed solution 8 | 13.00 | D1 | 2.00 | 0.133 | 180 | 28 | Excellent |
| Example 12 | 85.00 | No.1 | Mixed solution 9 | 15.00 | None | 0 | 0 | 1000 | 17 | Good |
| Example 13 | 85.00 | No.1 | Mixed solution 10 | 14.95 | D1 | 0.05 | 0.003 | 500 | 22 | Excellent |
| Example 14 | 85.00 | No.1 | Mixed solution 11 | 12.00 | D1 | 3.00 | 0.200 | 100 | 26 | Excellent |
| Example 15 | 85.00 | No.1 | Mixed solution 12 | 10.00 | D1 | 5.00 | 0.333 | 20 | 22 | Excellent |
| Example 16 | 85.00 | No.1 | Mixed solution 1 | 9.00 | D4 | 6.00 | 0.400 | 10 | 15 | Acceptable |
| Example 17 | 85.00 | No.5 | Mixed solution 1 | 14.00 | D1 | 1.00 | 0.067 | 200 | 26 | Excellent |
| Example 18 | 85.00 | No.6 | Mixed solution 1 | 14.00 | D1 | 1.00 | 0.067 | 200 | 27 | Excellent |

| | Silver powder | | Mixed solution | | Additive | | (Additive /binder) (mass ratio) | Binder exchange current density ($\mu$A/dm$^2$) | Joining strength of joined body (MPa) | Stability of silver paste |
|---|---|---|---|---|---|---|---|---|---|---|
| | Blending proportion (mass%) | Type | Type | Blending proportion (mass%) | Type | Blending proportion (mass%) | | | | |
| Example 19 | 85.00 | No.7 | Mixed solution 1 | 14.00 | D1 | 1.00 | 0.067 | 200 | 27 | Excellent |
| Example 20 | 85.00 | No.8 | Mixed solution 1 | 14.00 | D1 | 1.00 | 0.067 | 200 | 27 | Excellent |
| D1: Diethylene glycol<br>D2: Triethylene glycol<br>D3: Polyethylene glycol (molecular weight 1000)<br>D4: Benzoic acid<br>D5: Ethylene glycol | | | | | | | | | | |

EP 4 029 627 A1

TABLE 5

| | Silver powder | | Mixed solution | | Additive | | (Additive /binder) (mass ratio) | Binder exchange current density ($\mu$A/dm$^2$) | Joining strength of joined body (MPa) | Stability of silver paste |
|---|---|---|---|---|---|---|---|---|---|---|
| | Blending proportion (mass%) | Type | Type | Blending proportion (mass%) | Type | Blending proportion (mass%) | | | | |
| Example 21 | 85.00 | No.9 | Mixed solution 1 | 14.00 | D1 | 1.00 | 0.057 | 200 | 26 | Excellent |
| Example 22 | 85.00 | No. 10 | Mixed solution 1 | 14.00 | D1 | 1.00 | 0.057 | 200 | 28 | Excellent |
| Example 23 | 85.00 | No.1 | Mixed solution 13 | 14.00 | D1 | 1.00 | 0.067 | 220 | 29 | Excellent |
| Example 24 | 85.00 | No.1 | Mixed solution 14 | 14.00 | D1 | 1.00 | 0.067 | 150 | 29 | Excellent |
| Example 25 | 85.00 | No.1 | Mixed solution 15 | 14.00 | D1 | 1.00 | 0.067 | 240 | 27 | Excellent |
| Example 26 | 85.00 | No.1 | Mixed solution 16 | 14.00 | D1 | 1.00 | 0.067 | 240 | 30 | Excellent |
| Example 27 | 85.00 | No.1 | Mixed solution 17 | 14.00 | D1 | 1.00 | 0.067 | 190 | 27 | Excellent |
| Example 28 | 85.00 | No.1 | Mixed solution 18 | 14.00 | D1 | 1.00 | 0.067 | 200 | 26 | Excellent |
| Comparative Example 1 | 85.00 | No.1 | Mixed solution 20 | 15.00 | None | 0 | 0 | <1 | 10 | Excellent |

EP 4 029 627 A1

(continued)

| | Silver powder | | | Mixed solution | | Additive | | (Additive /binder) (mass ratio) | Binder exchange current density ($\mu A/dm^2$) | Joining strength of joined body (MPa) | Stability of silver paste |
|---|---|---|---|---|---|---|---|---|---|---|---|
| | Blending proportion (mass%) | Type | Type | Blending proportion (mass%) | Type | Blending proportion (mass%) | | | | | |
| Comparative Example 2 | 85.00 | No.1 | Mixed solution 21 | 15.00 | None | 0 | 0 | >10000 | Paste not formed | | |
| Comparative Example 3 | 85.00 | No.1 | Mixed solution 20 | 14.00 | D1 | 1.00 | 0.067 | <1 | 10 | Excellent |
| Comparative Example 4 | 85.00 | No.1 | Mixed solution 21 | 14.00 | D1 | 1.00 | 0.067 | 5000 | Paste not formed | | |
| Comparative Example 5 | 85.00 | No. 10 | Mixed solution 1 | 15.00 | None | 0 | 0 | 2000 | 6 | Good |
| Comparative Example 6 | 85.00 | No.1 | Mixed solution 7 | 15.00 | None | 0 | 0 | 3000 | 7 | Good |
| Comparative Example 7 | 85.00 | No.1 | Mixed solution 7 | 14.00 | D5 | 1.00 | 0.067 | 3000 | 9 | Acceptable |
| Comparative Example 8 | 85.00 | No.1 | Mixed solution 1 | 5.00 | D1 | 10.00 | 0.667 | 5 | 9 | Excellent |
| Comparative Example 9 | 85.00 | No.2 | Mixed solution 22 | 15.00 | None | 0 | 0 | 8 | 10 | Good |

D1: Diethylene glycol
D2: Triethylene glycol
D3: Polyethylene glycol (molecular weight 1000)
D4: Benzoic acid
D5: Ethylene glycol

22

EP 4 029 627 A1

As is obvious from Table 5, in Comparative Example 1, since a joined body was produced using a silver paste that included the mixed solution 20 (15.00% by mass), to which no fatty acid silver salt was added, and that did not include an additive, the exchange current density of the binder was extremely low such as less than 1 $\mu$A/dm$^2$, because no additive was included. In addition, since the mixed solution did not include a fatty acid silver salt, the joining strength of the joined body was as small as 10 MPa.

Furthermore, in Comparative Example 2, it was attempted to produce a joined body by using a silver paste that included the mixed solution 21 (15.00% by mass), to which no aliphatic amine was added, and that did not include an additive; however, a silver paste was not formed due to the fact that the mixed solution 21 did not include an aliphatic amine, a joined body could not be produced.

Furthermore, in Comparative Example 3, since a joined body was produced using a silver paste that included the mixed solution 20 (14.00% by mass), to which no fatty acid silver salt was added, and diethylene glycol (D1) (1.00% by mass) as the additive, even though the mass ratio of the additive with respect to the binder was 0.067, the mixed solution did not include a fatty acid silver salt, and the exchange current density of the binder was extremely low such as less than 1 $\mu$A/dm$^2$. Therefore, although diethylene glycol (additive) was used, the joining strength of the joined body was as small as 10 MPa.

Furthermore, in Comparative Example 4, it was attempted to produce a joined body by using a silver paste that included the mixed solution 21 (14.00% by mass), to which no aliphatic amine was added, and diethylene glycol (D1) (1.00% by mass) as the additive; however, since a silver paste was not formed due to the fact that the mixed solution 21 did not include an aliphatic amine, a joined body could not be produced.

Furthermore, in Comparative Example 5, since a joined body was produced using a silver paste that included the mixed solution 1 (15.00% by mass), to which a fatty acid silver salt and an aliphatic amine were added, and the silver powder of No. 10 (85.00% by mass) and that did not include an additive, the exchange current density of the binder was extremely high such as 2000 $\mu$A/dm$^2$ because no additive was included. Therefore, the joining strength of the joined body was as small as 6 MPa.

Furthermore, in Comparative Example 6, since a joined body was produced using a silver paste that included the mixed solution 7 (15.00% by mass), to which a fatty acid silver salt and an aliphatic amine were added, and that did not include an additive, the exchange current density of the binder was extremely high such as 3000 $\mu$A/dm$^2$ because no additive was included. Therefore, the joining strength of the joined body was as small as 7 MPa.

Furthermore, in Comparative Example 7, since a joined body was produced using a silver paste that included the mixed solution 7 (14.00% by mass), to which a fatty acid silver salt and an aliphatic amine were added, and that included ethylene glycol (D5) (1.00% by mass) as the additive, the exchange current density of the binder was extremely high such as 3000 $\mu$A/dm$^2$ because the additive was ethylene glycol. Therefore, the joining strength of the joined body was as small as 9 MPa.

Furthermore, in Comparative Example 8, since a joined body was produced using a silver paste that included the mixed solution 1 (5.00% by mass), to which a fatty acid silver salt and an aliphatic amine were added, and diethylene glycol (D1) (10.00% by mass) as the additive, the content (0.667) of diethylene glycol as the additive was too large, and therefore, the exchange current density of the binder was extremely low such as 5 $\mu$A/dm$^2$. Therefore, the joining strength of the joined body was as small as 9 MPa.

Furthermore, in Comparative Example 9, a silver paste that included the mixed solution 22 (15.00% by mass), to which a fatty acid silver salt and an aliphatic amine were added, and that did not include an additive, was prepared, and the solvent for the mixed solution 22 was polyethylene glycol (C7). In Comparative Example 9, since a joined body was produced using this silver paste, the exchange current density of the binder was extremely low such as 8 $\mu$A/dm$^2$ because no additive was included and polyethylene glycol (C7) was used as the solvent. Therefore, the joining strength of the joined body was as small as 10 MPa.

In contrast to these Comparative Examples 1, 3, and 5 to 9, in Examples 1 to 11 and 13 to 28, joined bodies were produced by using a silver paste that used a binder whose exchange current density was in the range specified in the first aspect of the present invention and that included a fatty acid silver salt, an aliphatic amine, and a solvent, or by using silver pastes produced by preparing and kneading the mixed solutions 1 to 18 including a fatty acid silver salt and an aliphatic amine with the "silver powders of No. 1 to No. 6" that included first silver particles having a particle size of 100 nm or more and less than 500 nm in the range of 55% by volume or more and 95% by volume or less, that included second silver particles having a particle size of 50 nm or more and less than 100 nm in the range of 5% by volume or more and 40% by volume or less, and that included third silver particles having a particle size of less than 50 nm in the range of 5% by volume or less, or the "silver powder of No. 10" that included 100% by volume of first silver particles having a particle size of 100 nm or more and less than 500 nm, and the additive defined in the second or third aspect of the present invention.

Furthermore, in Example 12, instead of using an additive, the mixed solution 9 including silver acetate, dodecylamine, and butyl carbitol acetate was used. Therefore, in Examples 1 to 28, it was found that the joining strength of the joined body increased to the range of from 15 MPa to 30 MPa, and a joined body having high joining strength was obtained.

The stability of the silver pastes was also "Acceptable", "Good" and "Excellent". Particularly, the stability of the silver pastes that used diethylene glycol (D1) and triethylene glycol (D2) as the additive was "Excellent", and the stability was high. This is presumed to be the effect of stabilizing the silver-amine complex.

INDUSTRIAL APPLICABILITY

The silver paste of the present invention can be utilized for a joining layer that joins semiconductor elements such as high-power LED elements and power semiconductor elements, and electronic components such as semiconductor packages, to copper or copper alloy members, which are substrates such as DBC substrates (copper-clad substrates) and lead frames. Therefore, the silver paste can be industrially utilized.

REFERENCE SIGNS LIST

1, 11: Copper or copper alloy member
1a, 11a: Surface of copper or copper alloy member
2, 12: Silver powder
3, 13: Silver paste layer
4, 14: Binder
15: Pseudo-silver plating film

**Claims**

1. A silver paste comprising:

   a silver powder; and
   a binder,
   wherein the binder includes at least a fatty acid silver salt and an aliphatic amine, and an exchange current density of the binder is within a range of 10 $\mu A/dm^2$ or more and 1000 $\mu A/dm^2$ or less.

2. The silver paste according to Claim 1, wherein the binder includes, as an additive, at least one of diethylene glycol, triethylene glycol, polyethylene glycol, and benzoic acid.

3. The silver paste according to Claim 1 or 2, wherein a content of the additive in the binder is within a range of 0.003 or more and 0.333 or less in terms of mass ratio, additive/binder.

4. The silver paste according to any one of Claims 1 to 3, wherein the silver powder includes:

   first silver particles having a particle size of 100 nm or more and less than 500 nm in a range of 55% by volume or more and 95% by volume or less,
   second silver particles having a particle size of 50 nm or more and less than 100 nm in a range of 5% by volume or more and 40% by volume or less, and
   third silver particles having a particle size of less than 50 nm in a range of 5% by volume or less.

5. A method for producing a silver paste, the method comprising:

   a step of mixing a fatty acid silver salt and an aliphatic amine, or mixing a fatty acid silver salt, an aliphatic amine, and a solvent excluding a glycol-based solvent, to obtain a mixture;
   a step of heating the mixture, stirring the mixture, and then cooling the mixture to obtain a mixed solution; and
   a step of kneading the mixed solution, a silver powder, and the additive recited in Claim 2 or 3 to obtain a silver paste.

6. A method for producing a joined body, the method comprising:

   a step of applying the silver paste according to any one of Claims 1 to 4 directly on a surface of a copper or copper alloy member to form a silver paste layer;

a step of laminating an electronic component on the silver paste layer to produce a laminated body; and

a step of heating the laminated body in a nitrogen atmosphere having an oxygen concentration of 1000 ppm or less on a volume basis, thereby sintering the silver powder in the silver paste layer to form a joining layer, and producing a joined body in which the copper or copper alloy member and the electronic component are joined with the joining layer interposed therebetween.

# FIG. 1

(a)

(HEATING)

(b)

FIG. 2

(a)

(HEATING)

(b)

**INTERNATIONAL SEARCH REPORT**

International application No.

PCT/JP2020/046723

### A. CLASSIFICATION OF SUBJECT MATTER

B22F 1/00(2006.01)i; B22F 7/08(2006.01)i; B22F 9/00(2006.01)i; B82Y 30/00(2011.01)i; B82Y40/00(2011.01)i; H01B1/00(2006.01)i; H01B 1/22(2006.01)i; H01B 13/00(2006.01)i; H01L 21/52(2006.01)i; H05K 3/32(2006.01)i

FI: B22F9/00 B; H01B1/22 A; H01B13/00 Z; B22F1/00 K; B22F7/08 C; H05K3/32 B; B82Y30/00; B82Y40/00; H01L21/52 E; H01B1/00 K

According to International Patent Classification (IPC) or to both national classification and IPC

### B. FIELDS SEARCHED

Minimum documentation searched (classification system followed by classification symbols)

B22F1/00; B22F7/08; B22F9/00; B82Y30/00; B82Y40/00; H01B1/00; H01B1/22; H01B13/00; H01L21/52; H05K3/32

Documentation searched other than minimum documentation to the extent that such documents are included in the fields searched

| | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2008-176951 A (MITSUBISHI CHEMICAL CORP.) 31 July 2008 (2008-07-31) | 1-6 |
| A | JP 2008-198595 A (MITSUBISHI CHEMICAL CORP.) 28 August 2008 (2008-08-28) | 1-6 |
| A | WO 2012/133767 A1 (NAMICS CORP.) 04 October 2012 (2012-10-04) | 1-6 |
| A | CN 108102579 A (KUNMING INSTITUTE OF PRECIOUS METALS) 01 June 2018 (2018-06-01) | 1-6 |

☐ Further documents are listed in the continuation of Box C.  ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 24 February 2021 (24.02.2021) | 09 March 2021 (09.03.2021) |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

<div align="center">

**INTERNATIONAL SEARCH REPORT**

Information on patent family members

</div>

International application No.

PCT/JP2020/046723

| Patent Documents referred in the Report | Publication Date | Patent Family | Publication Date |
|---|---|---|---|
| JP 2008-176951 A | 31 Jul. 2008 | (Family: none) | |
| JP 2008-198595 A | 28 Aug. 2008 | (Family: none) | |
| WO 2012/133767 A1 | 14 Oct. 2012 | TW 201247859 A | |
| CN 108102579 A | 01 Jun. 2018 | (Family: none) | |

Form PCT/ISA/210 (patent family annex) (January 2015)

**REFERENCES CITED IN THE DESCRIPTION**

**Patent documents cited in the description**

- JP 2019228845 A
- JP 2020204335 A
- JP 5872545 B
- JP 6329703 B